# EUROPEAN PATENT SPECIFICATION

(11) **EP 0 903 753 B1**
(45) Date of publication and mention of the grant of the patent: **20.03.2002**
(21) Application number: 98121758.1
(22) Date of filing: 29.12.1992
(51) Int. Cl.: G11C 29/00, G11C 16/06

(54) **Nonvolatile semiconductor memory**
Nicht-flüchtige Halbleiter-Speicher-Vorrichtung
Dispositif de mémoire à semiconducteur non volatile

(30) Priority: 13.10.1992 JP 27435592; 27.12.1991 JP 34666391
(43) Date of publication of application: 24.03.1999
(62) Divisional of application: 92311829.3
(73) Proprietor: FUJITSU LIMITED, Kawasaki-shi, Kanagawa 211-8588 (JP)
(72) Inventor: Kasa, Yasushi, c/o Fujitsu Ltd., Kawasaki-shi, Kanagawa 211-8588 (JP); Akaogi,Takao, c/o Fujitsu Ltd., Kawasaki-shi, Kanagawa 211-8588 (JP)
(74) Representative: Hitching, Peter Matthew

(56) References cited:
- EP-A- 0 517 354
- WO-A-90/12400
- US-A- 4 460 982
- US-A- 4 811 294
- US-A- 5 293 333

## Description

This invention relates to a nonvolatile semiconductor memory, particularly to an EPROM and an EEPROM including a nonvolatile memory circuit and, more particularly to a circuit construction of a nonvolatile semiconductor memory of the batch erasure type (hereinafter referred to as a flash memory).

The invention further relates particularly to a circuit construction concerning an improvement in the speed of an erase verify operation in a nonvolatile semiconductor memory.

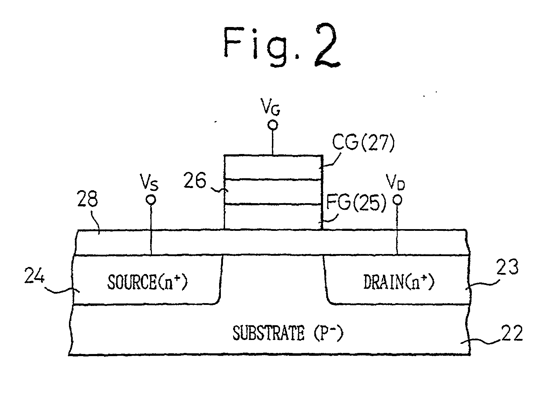

Fig. 2 of the accompanying drawings shows diagrammatically a structure of a cell used in a flash memory.

In this figure, indicated at V_{G} is a gate terminal, at V_{D} a drain terminal, at V_{S} a source terminal, at 27 a control gate CG connected to the gate terminal V_{G}, and at 25 a floating gate FG which is controlled by the potential of the control gate CG.

Further, indicated at 22 is a semiconductor substrate, e.g. a semiconductor substrate having P-type conductivity. On the semiconductor substrate 22 are mounted well portions 23, 24 made of semiconductor having N-type conductivity. The well portion 23 forms a drain while the well portion 24 forms a source. Indicated at 26, 28 are insulating films.

When data is read from the cell, 0V is applied to the source terminal V_{S}, a read voltage (normal supply. voltage V_{CC}) of 5V is applied to the gate terminal V_{G}, and a voltage of about 1V is applied to the drain terminal V_{D}. Then, it is discriminated whether the read data is "1" or "0" depending upon whether a current flows through the cell. On the other hand, when data is written in the cell, 0V is applied to the source terminal V_{S}, a write/erase voltage V_{PP} of about 12V is applied to the gate terminal V_{G}, and a write drain voltage V_{W} (lower than V_{PP}) is applied to the drain terminal V_{D}. Thereby, electrons are injected into the floating gate FG from a drain region (writing operation). Further, when the data is erased, the drain terminal V_{D} is brought into an open state, and 0V and the write/erase voltage V_{PP} are applied to the gate terminal V_{G} and the source terminal V_{S} respectively. Thereby, the electrons are taken from the floating gate FG to a source region (erasing operation).

When the data is written, it is required to check whether the data is written sufficiently in the memory cell (write verification). Likewise, when the data is erased, it is required to check whether the data is erased sufficiently from the memory cell (erase verification).

The write verification and erase verification are carried out so as to confirm whether the degree of writing and the degree of erasing have a sufficient margin for the read voltage, i.e. a variation range of the normal supply voltage V_{CC} (5V ± 0.5V). Generally, these verifications are carried out to confirm that an operation margin of about 0.5V to 1.0V is available for a voltage range of V_{CC}. In this case, the verify voltage including the operation margin is 6V to 6.5V in the write verification, and 3.5V to 4V in the erase verification.

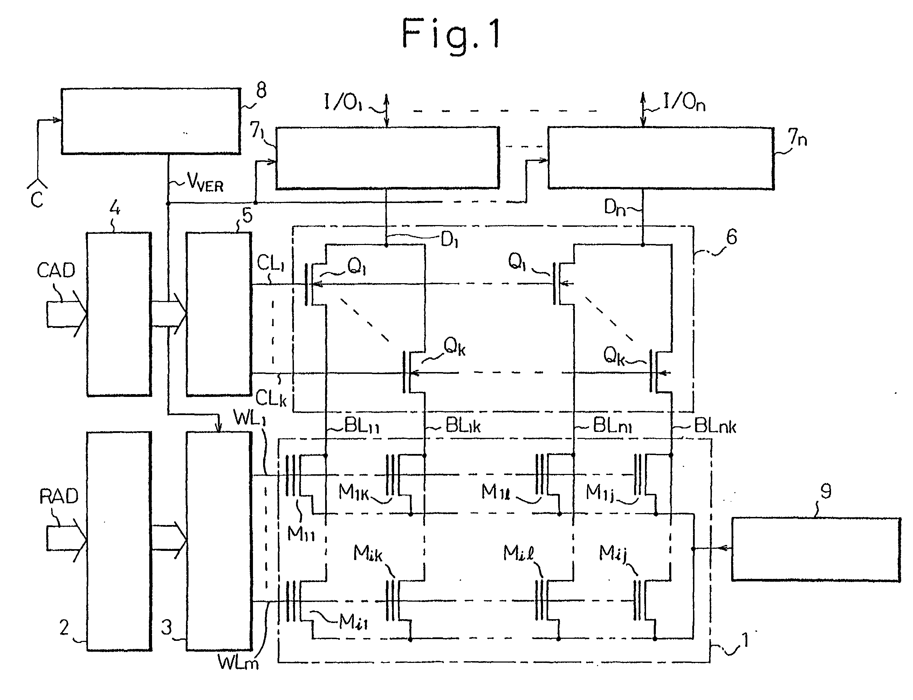

It is expected that the write verification and the erase verification can be accomplished easily if the verify voltage including the operation margin to be secured is applied to word lines (for example, word lines WL₁ to WLₘ of the flash memory shown in Fig. 1), so that the sensitivity of the S/A circuit is the same regardless of whether the voltage V_{CC} or the verify voltage is applied as the supply voltage of the S/A circuit.

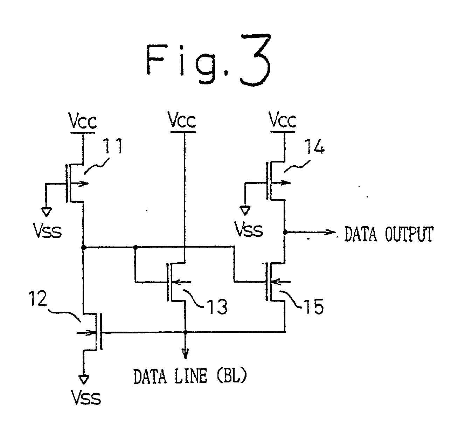

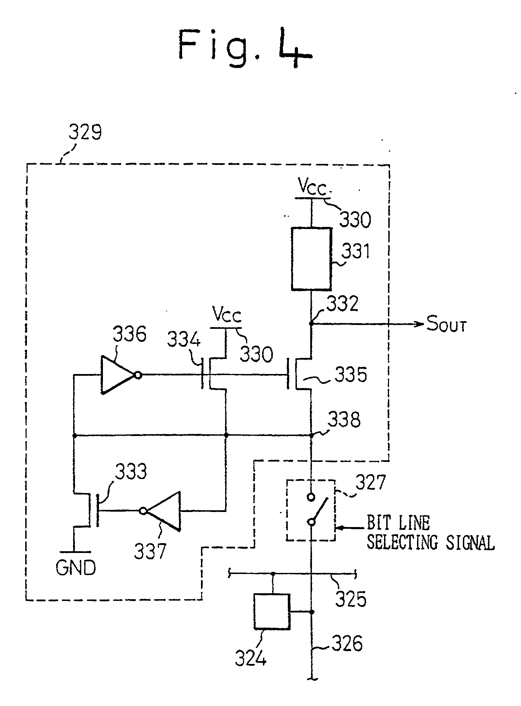

Fig. 3 of the accompanying drawings shows a construction of a general S/A circuit used in the nonvolatile semiconductor memory such as an EPROM.

In this figure, indicated at V_{CC} is a line of a supply voltage 5V, and at V_{SS} a line of a supply voltage 0V. Between the power supply lines V_{CC} and V_{SS} are connected a p-channel transistor 11 and an n-channel transistor 12 in series. A gate of the transistor 11 is connected to power supply line V_{SS}, while a gate of the transistor 12 is connected to a data line (i.e. a bit line). Between the power supply line V_{CC} and the data line is connected an n-channel transistor 13 whose gate is connected to drains of the respective transistors 11, 12. Likewise, between the power supply line V_{CC} and the data line are connected a p-channel transistor 14 and an n-channel transistor 15 in series. A gate of the transistor 14 is connected to the power supply line V_{SS}, while a gate of the transistor 15 is connected to the drains of the respective transistors 11, 12. An output (data output) of the S/A circuit is taken from drains of the respective transistors 14, 15.

In this construction, when the data read from the memory cell is "1", i.e. when the level of the data line is "H", the transistor 12 is turned on and thereby a drain potential thereof is reduced to "L" level. Accordingly, the transistor 15 is cut off. Thus, the voltage of "H" level is output from the power supply line V_{CC} through the transistor 14 (data output). In other words, the data having the same level as the read data is sensed. Conversely, when the data read from the memory cell is "0", the transistor 12 is cut off and the voltage of "H" level is fed from the power supply line V_{CC} through the transistor 11 to the gate of the transistor 15 to turn the transistor 15 on. Thereupon, the level of a data output line is reduced to "L" (the data of "L" level is the same as the read data).

In this way, the transistor 15 is provided with a function of transmitting the level of the bit line to the data output line (bit line level adjustment), and the transistor 14 is provided with a function of discriminating the data of the memory cell according to the state (on/off) of the transistor 15.

In recent years, a high speed operation has been aimed at. However, there is a limit in carrying out the data writing, data reading, and erasing operations at a high speed in the conventional nonvolatile semiconductor memory in terms of its circuit construction and software, thus realization of higher operations are earnestly demanded.

Further, in the nonvolatile semiconductor memory of the prior art, since there is variation in an erasing characteristic of the memory cell transistors, it takes time to erase the information written in the memory reliably, which creates a risk of erasing even necessary information. In view of these problems, it is desirable to provide a nonvolatile semiconductor memory capable of shortening an erase verifying time and a time required to erase information, and/or of carrying out an erasing operation such that there is no memory cell transistor having necessary information erased therefrom.

The invention is specified by claims 1, 15 und 18. According to an embodiment of the present invention, there is provided a nonvolatile semiconductor memory comprising a cell matrix circuit (1) having erasable nonvolatile memory cell transistors (Mᵢⱼ) arranged at intersections of a plurality of word lines (WL₁ to WLₘ) and a plurality of bit lines (BL₁₁ to BL₁ₖ, ..., BLₙ₁ to BLₙₖ); a row decoding circuit (3); a column decoding circuit (5); and sense amplifying circuits (7₁ to 7ₙ) connected to the respective bit lines (BL₁₁ to BL₁ₖ, ..., BLₙ₁ to BLₙₖ) of the cell matrix circuit (1). Memory cell transistors included in the cell matrix circuit in the aforementioned nonvolatile semiconductor memories are connected in parallel with one another while being in on-states, and the cell matrix circuit has voltage discriminating means connected thereto, the voltage discriminating means including voltage detecting means for detecting a generated voltage in response to a current flowing through all the memory cell transistors, reference voltage generating means, and comparing means for comparing an output voltage from the voltage detecting means and a reference voltage output from the reference voltage generating means.

In a first preferred embodiment a predetermined voltage is applied to a source line to which the cell transistors are commonly connected at the sources thereof, the same or different positive voltage are applied to all or a part of the plurality of word lines forming the control gates of the plurality of cell transistors; and the plurality of cell transistors are connected at the drains thereof commonly to the data bus to which the voltage judgement circuit is also connected. For an erase verify operation, the voltage judgement circuit applies the same or different positive voltages higher than the predetermined voltages to all or a part of the plurality of word lines that form the control gates of the plurality of cell transistors connected at the sources thereof to a common source line and this source line, and when a data bus (provided correspondingly to the plurality of bit lines to which the plurality of cell transistors are connected at the drains thereof) is connected to all or a part of the plurality of bit lines, the judgement circuit compares the voltage on the data bus with a predetermined reference voltage to judge whether or not the voltage at all or a part of the drains of the plurality of cell transistors has reached a value derived by subtracting from the positive voltage applied to the word lines a lower limit threshold permitted for the plurality of cell transistors.

More particularly, in the first embodiment, the same or different positive voltages higher than predetermined voltages are applied to, for example, the plurality of word lines and the source line, for erasure verification, and when the data bus is connected to the plurality of bit lines, the drain voltage of the plurality of cell transistors will be a value derived by "subtraction of a threshold value of the cell transistor for which the erase rate is highest (lowest threshold value of all the cell transistors) from the positive voltage applied to the word lines".

In the first embodiment, the voltage judgement circuit judges whether or not the drain voltage of the plurality of cell transistors has reached a value derived by "subtraction of a permitted lower limit threshold value from the positive voltage applied to the word lines". When "the threshold value of the cell transistor for which the erase rate is highest equals the permitted lower threshold value", the drain voltage of the plurality of cell transistors will be a value derived by a "subtraction of the permitted lower limit threshold value from the positive voltage applied to the word lines".

In other words, when the drain voltage of the plurality of cell transistors has reached a value derived by "substraction of the permitted lower limit threshold from the positive voltage applied to the word lines", it can be decided that the threshold of the cell transistor for which the erase rate is highest has reached the permitted lower limit threshold. Also in this case, it can be decided that the threshold of the cell transistor for which the erase rate is lowest has reached the permitted upper limit threshold.

Namely, in this first embodiment, the same or different positive voltage are applied to the plurality of word lines and the source line, respectively, and the data bus is connected to all of the bit lines. The voltage judgement circuit judges whether or not the drain voltage of the plurality of cell transistors has reached the value derived by "subtraction of the permitted lower limit threshold value from the positive voltage applied to the word lines", thereby permitting erasure verification for the plurality of cell transistors at one time.

According to the first embodiment described above, erase verification can be made simultaneously for a plurality of memory cell transistors, and consequently all the memory cell transistors need not be read out one by one. Therefore, the erase verification time can be shortened.

According to the first embodiment, erase verification can be made by detecting the case where the threshold value of the memory cell transistor having the highest erase rate reaches the allowed lower limit threshold value. Therefore, the erasing operation can be carried out without causing any memory cell transistors to be over-erased.

Incidentally, if erase verification is then performed by the prior art method after the threshold value of the memory cell transistor having the highest erase rate has reached the allowed lower limit threshold value, it is possible to confirm the existence of any memory cell transistors exhibiting a greater threshold value than the threshold value after erasure permitted for the memory cell transistor having the lowest erase rate, and thus to detect defects in the devices.

In such a case, erase verification by the prior art method needs to be carried out only once for each memory cell transistor. Therefore, the overall erase verify time can be made shorter than in the prior art method.

Furthermore, this first embodiment includes the voltage judgement circuit for judging whether or not the drain voltage of all, or a part, of a plurality of memory cell transistors has reached the difference obtained by subtracting the allowed lower limit threshold value from the positive voltage applied to the word lines, by comparing the voltage of the data bus with a predetermined reference voltage. Therefore, erase verification can be executed for those memory cell transistors which share a common bit line, or for each memory cell transistor in turn.

In this case, the same or different voltages above predetermined voltage values are applied to a part of a plurality of word lines and to the source lines, and the data bus is connected to a part of a plurality of bit lines at the time of erase verify.

In a second embodiment, for erasure verification the voltage judgement circuit applies the same or different positive voltages higher than the predetermined voltages to all or a part of the plurality of word lines that form the control gates of the plurality of cell transistors connected at the sources thereof to a common source line and to a data bus provided correspondingly to the plurality of bit lines to which the plurality of cell transistors are connected at the drains thereof, and when the data bus is connected to all or a part of the plurality of bit lines, the judgement circuit compares the voltage on the source line with a predetermined reference voltage to judge whether or not the voltage at all or a part of the sources of the plurality of cell transistors has reached a value derived by subtracting from the positive voltage applied to the word lines the lower limit threshold permitted for the plurality of cell transistors.

In the second embodiment, when the same or different positive voltages above predetermined voltage values are applied to all of a plurality of word lines and to the data bus, and a plurality of bit lines are connected together at the time of erase verify, for example, the source voltage of a plurality of memory cell transistors becomes equal to [positive voltage applied to the word lines] - [the threshold value of the memory cell transistor having the highest erase rate].

In this second embodiment, the voltage judgement circuit judges whether or not the source voltage of a plurality of memory cell transistors reaches a predetermined reference potential difference equal to [the positive voltage applied to the word lines] - [the allowed lower limit threshold value]. When [the threshold value of the memory cell transistor having the lowest erase time] is equal to [the allowed lower limit threshold value], the source voltage of a plurality of memory cell transistor reaches the difference, that is, [the positive voltage applied to the word lines] - [the allowed lower limit threshold value].

In other words, when the source voltage of a plurality of memory cell transistors reaches the reference potential difference, i.e. [the positive voltage applied to the word lines] - [the allowed lower limit threshold value], the threshold value of the memory cell transistor having the highest erase rate can be judged as reaching the allowed lower limit threshold value. In this case, the threshold value of the memory cell transistor having the lowest erase rate can be judged as reaching the allowed upper limit threshold value.

In other words, the second embodiment can simultaneously execute erase verify for a plurality of memory cell transistors by applying the same or different positive voltages above predetermined voltages to all of a plurality of word lines and to the data bus at the time of erase verify, connecting the data bus to all of a plurality of bit lines, and judging by the voltage judgement circuit whether or not the source voltage of a plurality of memory cell transistors reaches the difference obtained by subtracting the allowed lower limit threshold value from the positive voltage applied to the word lines.

As described above, the second embodiment can simultaneously execute erase verification for a plurality of memory cell transistors in the same way as the first embodiment. Since all the memory cell transistors need not be read out one by one, the erase verify time can be shortened.

The second embodiment can execute erase verification by detecting the point of time when the threshold value of the memory cell transistor having the highest erase rate reaches the allowed lower limit threshold value. Therefore, the second embodiment can carry out the erasing operation without causing any memory cell transistors to be over-erased.

When erase verification is then carried out by the prior art method after the threshold value of the memory cell transistor having the highest erase rate has reached the allowed limit threshold value, the existence of any memory cell transistors which exhibit a greater threshold value than the threshold value after erasure allowed for the memory cell transistor having the lowest erase rate can be confirmed, and any defects in the devices can be discovered.

In such a case, too, erase verification according to the prior art method may be carried out only once. Therefore, the erase verify time can be made shorter than in the prior art method.

The second embodiment includes the voltage judgement circuit for judging whether or not the source voltage of all, or a part, of a plurality of memory cell transistors has reached the voltage value obtained by subtracting the allowed lower limit threshold value from the positive voltage applied to the word lines. For this reason, erase verification can be carried out for those memory cell transistors which share a common bit line, or for each memory cell transistor.

In this case, the same or different positive voltages exceeding the predetermined voltage values are applied to a part of a plurality of word lines and to the data bus at the time of erase verify, and the data bus is connected to a part of a plurality of bit lines.

Reference will now be made, by way of example, to the accompanying drawings, in which:
Fig. 1 is a diagram showing the overall construction of a flash memory to which an embodiment of the present invention can be applied;
Fig. 2 is a diagram showing a cell structure for explaining an operation of the flash memory;
Fig. 3 is a circuit diagram showing a construction of a S/A circuit as an example of the prior art;
Fig. 4 is a diagram showing the principle of another sense amplifier suitable for use in an embodiment of the present invention;
Fig. 5 is a chart showing a relationship between an erasing time and a threshold value of a memory cell transistor;
Fig. 6 is a flow chart showing a procedure of erasure carried out in a conventional flash type memory;
Fig. 7 is a circuit diagram showing parts of a first embodiment of the present invention;
Fig. 8 is a chart showing a relationship between the erasing time and the threshold value of a memory cell transistor in an embodiment of the present invention;
Fig. 9 is a flow chart showing a procedure of erasure carried out in the first embodiment of the present invention;
Fig. 10 is a circuit diagram showing parts of a second embodiment of the present invention;
Fig. 11 is a flow chart showing a procedure of erasure carried out in the second embodiment of the present invention;
Fig. 1 is a block diagram showing parts of an overall construction of a flash type memory to which an embodiment of the present invention can be applied.

In this figure, indicated at 1 is a cell array formed by arranging erasable nonvolatile memory cells Mᵢⱼ at intersections of a plurality of word lines WL₁ to WLₙ and a plurality of bit lines BL₁₁ to BL₁ₖ, ..., BLₙ₁ to BLₙₖ. In this embodiment, the cell array is divided into n blocks, in each of which (k × m) memory cells are arranged. Indicated at 2 is a row address buffer for buffering a row address RAD of an address signal fed externally thereto, at 3 a row decoder for decoding the row address and selecting any one of the word lines WL₁ to WLₙ, at 4 a column address buffer for buffering a column address CAD of the address signal, and at 5 a column decoder for decoding the column address and selecting any one of column lines CL₁ to CLₖ corresponding to the bit lines BLiₗ to BLiₖ for each of the aforementioned blocks. Indicated at 6 is a column gate circuit including transfer gate transistors Q₁ to Qₖ corresponding to the bit lines BLᵢₗ to BLᵢₖ for each of the aforementioned blocks. The respective transistors Q₁ to Qₖ are turned on when the corresponding column lines CL₁ to CLₖ are selected, to thereby connect the selected bit line BLᵢⱼ to a data line Dᵢ.

Indicated at 7₁ to 7ₙ are respectively writing circuits and S/A circuits for applying amplification to a write data and sense amplification to a read data between corresponding internal data lines D₁ to Dₙ and external input/output data lines I/O₁ to I/Oₙ. Indicated at 8 is a verify source voltage generating circuit for generating a verify voltage V_{VER} in accordance with a control signal C fed externally thereto. The generated verify source voltage V_{VER} is supplied to the selected word lines WL₁ to WLₙ through the row decoder 3 as described later, and to the S/A circuit corresponding to the selected word line. Indicated at 9 is a source voltage supply circuit for supplying a source voltage in common to the respective sources of the nonvolatile memory cells Mᵢⱼ.

It may sometimes be necessary to erase predetermined information once written into the memory cell transistor; however, a method thereby providing easy and positive erasure of such information has not been proposed heretofore.

More particularly, for erasing the memory cell transistor in the flash-type memory etc., erase verify operations are to be done to verify whether the information has been positively erased. However, it is difficult to determine when the erasing operation has been completed and no appropriate method has been proposed heretofore.

The memory cell transistors forming together a cell array in a flash-type memory vary in characteristics from one to another even in the case of similar manufacturing process. Thus, when memory cell transistor are erased under the same conditions, certain transistors may be sufficiently erased while others may be not be sufficiently erased.

If all the memory cell transistors are erased based on the erasure extent of a low-erase-speed memory cell transistor, the memory cell transistors for which the erase rate is higher will be over-erased and cannot be used again.

Also, if all the memory cell transistors are erased in a way appropriate for a high-erase-speed memory cell transistor many of them will not be sufficiently erased and further write operations cannot be made to these transistors.

Therefore, heretofore elaborate erasure methods have been used.

Specifically, in one such method used in a flash-type memory, erasure and verification (verification of whether the erasure has been completed) are repeatedly effected during an erasure so that no memory cell transistors (called cell transistors from now on) will remain under-erased. No cell transistors should be over-erased. However, this conventional erasing operation is effected using an address for an individual cell transistor, which causes the erasure time to be extremely long, and it is necessary that this erasure time be shortened.

Accordingly, it is desirable to overcome such drawbacks of the conventional technique and to provide a flash-type memory in which the erase/verify can be done in a short time, thereby shortening the erase time, without over-erasure of any cell transistors.

One example of a flash-type memory is shown in Fig. 1, and one example of the configuration of a sense amplifier for use in such a memory is shown in Fig. 4.

For erase verify in a flash-type memory having such a configuration, the word lines WL0 to WL2, for example, are applied with the same voltage as the post-erase threshold required for the cell transistors that are erased at the lowest speed, that is, the upper limit threshold permitted for the cell transistors M11₀₀ to M11ⱼⱼ, taking into consideration the variance in characteristics of the cell transistors. This voltage is a voltage based on the fact that it must be possible to judge whether or not a current flows to the cell transistors M11₀₀ to M11ⱼⱼ, when each one of the cell transistors is read respectively; in this case, the applied voltage may be the power-supply voltage Vcc.

More particularly, a previously-considered flash-type memory, when the erase verify operation is being carried out, if no current flows to the cell transistors M11₀₀ to M11ⱼⱼ when they are read individually for erasure verification, namely, if the voltage at the node 332 in Fig. 4 is equal to a reference voltage Vref, the erasure is determined to be insufficient (under-erase). If the voltage is smaller than Vref, it is determined that the erasure is completed.

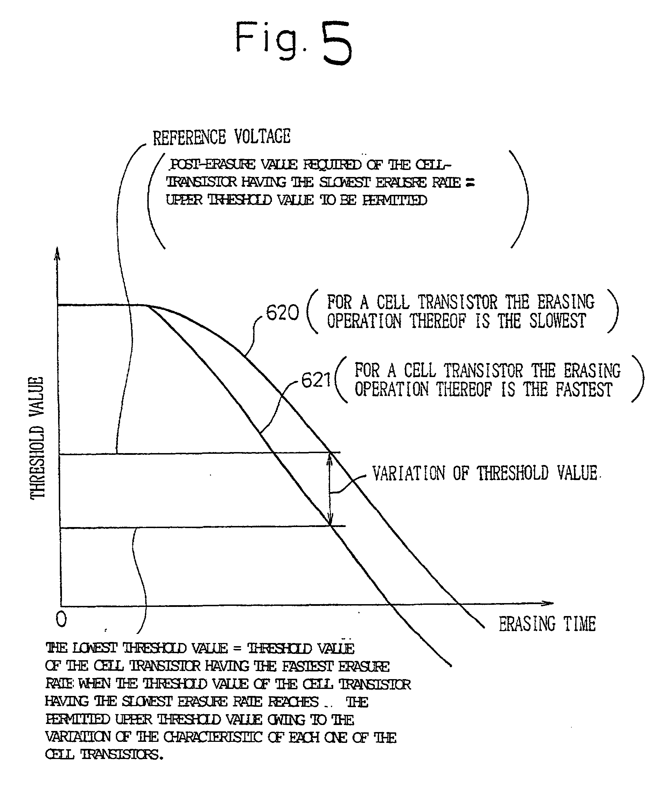

Fig. 5 shows the relation between the erase time and the threshold of the cell transistors M11₀₀ to M11ⱼⱼ. The solid line 620 is for the cell transistor for which the erase rate is lowest, and the solid line 621 is for the cell that can be erased at the highest speed.

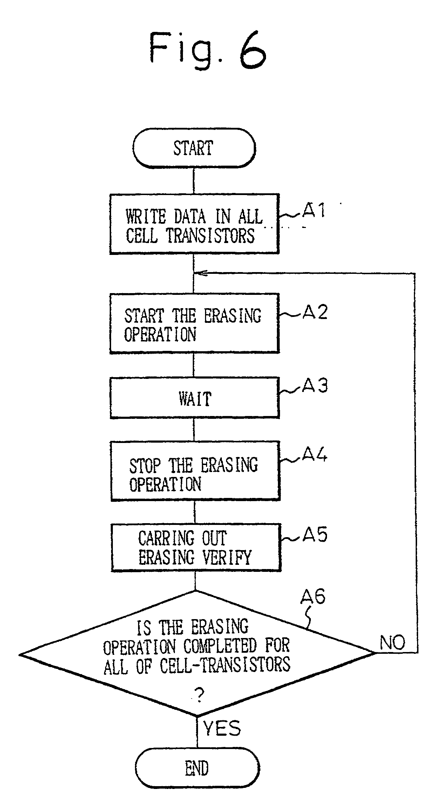

In a previously-considered flash-type memory, the erasure is done by taking as a reference potential the post-erase threshold for the cell transistor having the lowest-speed erasure characteristic, that is, to a permitted upper limit threshold shown in Figure 5, so that the erasure is deemed to be completed when the threshold of the cell transistor for which the erase rate is lowest reaches the upper limit threshold. The erasure is done following the procedure shown in Fig. 6.

More particularly, a write for all the cell transistors M11₀₀ to M11ⱼⱼ is done first (step A1), and then an erasing operation is started (step A2). After waiting a predetermined time (erasing operation continues - step A3) the erasing operation is stopped (step A4).

Thereafter, the cell transistors M11₀₀ to M11ⱼⱼ are read individually, and the voltage at the node 332 of the sense amplifier 329 is compared with the reference voltage Vref for the erase verify operation (step A5).

Then it is determined whether or not he voltage at the node 332 is smaller than Vref for all the cell transistors M11₀₀ to M11ⱼⱼ, namely, whether or not all the cell transistors M11₀₀ to M11ⱼⱼ have successfully been erased (step A6).

If all the cell transistors M11₀₀ to M11ⱼⱼ have not yet been erased (judgement of NO at step A6), the operation returns to step A2. When all of them have been erased (YES at step A6), the erasing operation is terminated.

In such conventional flash-type memory, the cell transistors M11₀₀ to M11ⱼⱼ are read one by one and only one of them is subject to the erasure verification at a time.

In other words, for each sense amplifier, only one cell transistor can be subject to the erase verify operation at a time, which causes the total erase verify operation time to be long and further leads to a long erasure time.

Also because of the configuration of the conventional flash-type memory, completion of the erasure of all the cell transistors M11₀₀ to M11ⱼⱼ is judged by checking that the threshold of the cell transistor for which the erase rate is lowest reaches the permitted upper limit threshold.

Thus, it is impossible to avoid the situation where the cell transistor for which the erase rate is high is over-erased. It also means that over-erased cell transistors will be mixed in with correctly-erased cell transistors after the erasure procedure is finished.

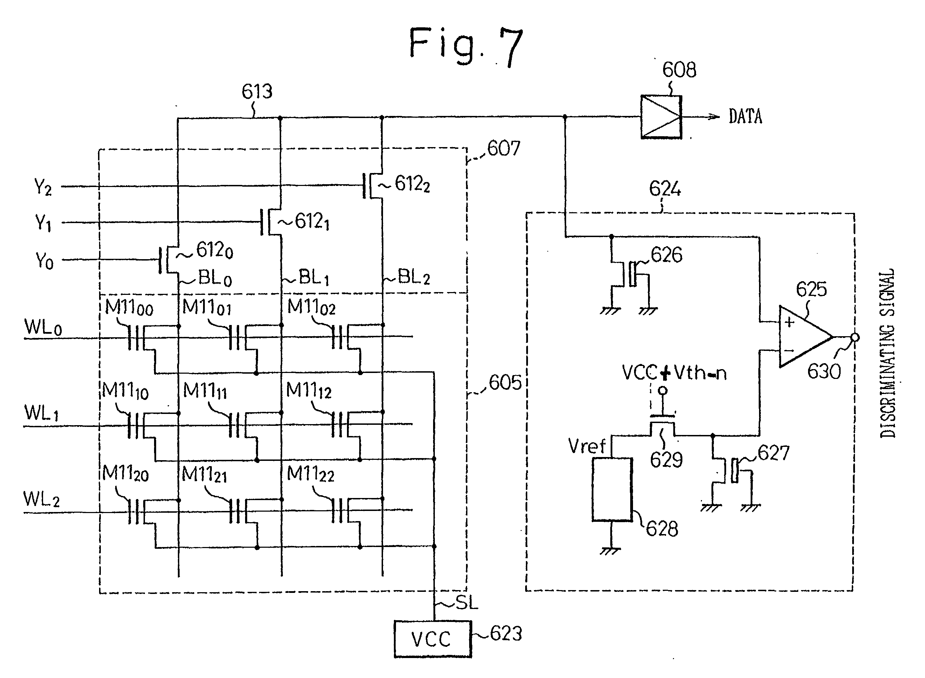

Fig. 7 is a circuit diagram showing portions of a first embodiment of the present invention. In the drawing, symbol SL represents a source line to which the sources of the memory cell transistors M11₀₀ to M11₂₂ are connected. In this embodiment, there is disposed a voltage supply circuit 623 for supplying a power supply voltage VCC to the source line SL at the time of erase verify.

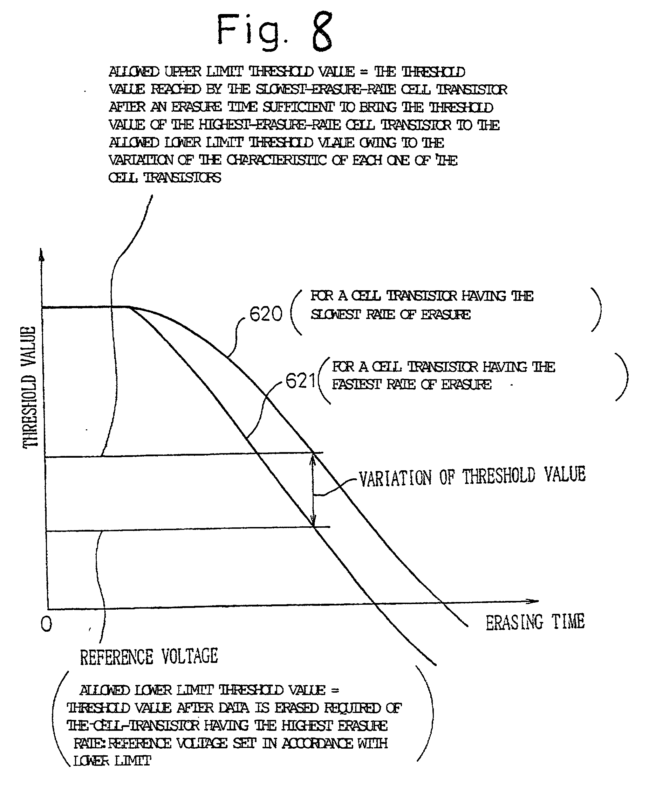

There is disposed a voltage judgement circuit 624 which judges whether or not he voltage of a data bus 613 is greater than the difference obtained by subtracting from VCC an allowed lower limit threshold value (see Figure 8) of the memory cell transistors M11₀₀ to M11₂₂. The rest of the circuit construction is the same as that of the flash memory shown in Fig. 1.

In the voltage judgement circuit 624, reference numeral 625 denotes an operational amplifier which constitutes a comparator, reference numerals 626 and 627 denote depletion type n-MOS transistors each constituting a load, and reference numeral 628 denotes a reference voltage generation circuit for generating a reference voltage Vref. The reference voltage Vref is set to be the difference obtained by subtracting from VCC the allowed lower limit threshold value of the memory cell transistors M11₀₀ to M11₂₂.

Reference numeral 629 denotes an enhancement type n-MOS transistor having the same size as that of n-MOS transistors 612₀ to 612₂ of a column gate circuit 607. A voltage of VCC + Vₜₕ₋ₙ (an n-MOS transistor threshold voltage) is applied to the gate of the n-MOS transistor 629 at the time of erase verify. Reference numeral 630 denotes a judgement output terminal from which the judgement is output.

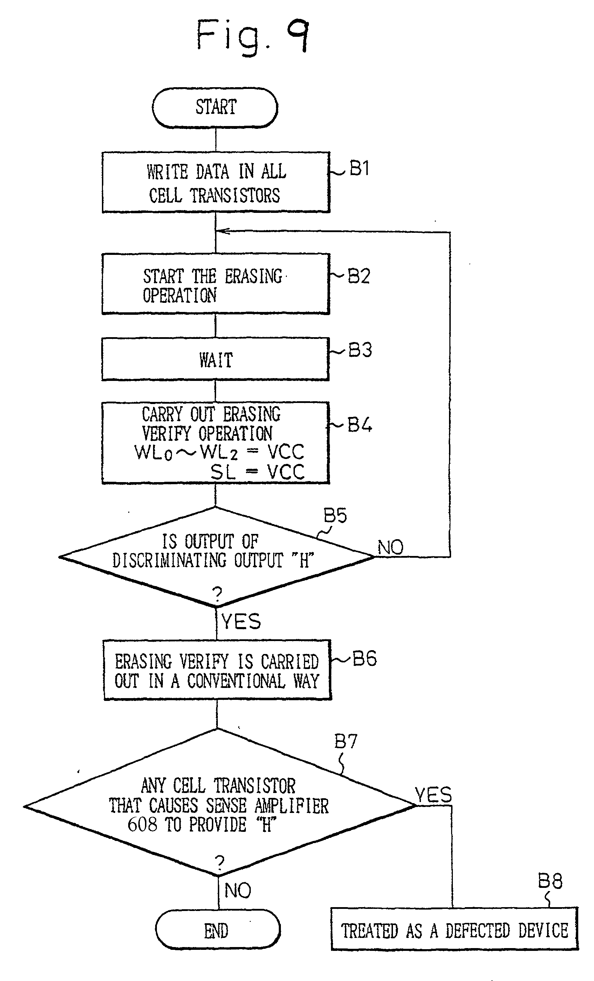

In this first embodiment, erase verification is carried out with the reference voltage set in accordance with the post-erasure threshold value required of the memory cell transistor having the highest erase rate, that is, the allowed lower limit threshold value. It is first confirmed whether or not the threshold value of the memory cell transistor having the highest erase rate has reached the reference voltage, and then erase verify is carried out by the prior art method. More definitely, the erasing operation is carried out in the sequence shown in Fig. 9.

In other words, in this embodiment of the present invention, the memory cell transistor having the highest erase rate among the memory cell transistors is focused on, and the threshold value Vₜₕ at which the memory cell transistor having the highest erase rate should be judged to be erased is used to set the reference potential.

As shown in Figure 8 the cell transistors will inevitably have threshold values which vary within a range of values having the threshold value Vₜₕ as its lower limit but it is assumed that when the highest-erase-rate cell transistor is judged as being erased (i.e. its threshold value has fallen to the allowed lower limit value) all the memory cell transistors in the memory cell array can be judged as being erased (i.e. all of them are assumed to have threshold values lower than an allowed upper limit value of the range).

To begin with, a write to all the memory cell transistors M11₀₀ to M11₂₂ is carried out (step B1). Next, after the erasing operation is started, a wait state (the erasing operation holding state) is maintained for a predetermined time (steps B2 and B3).

Incidentally, the erasing operation may be carried out by setting the source line to SL to VCC, the word lines WL₀ - WL₂ to a negative potential, and the bit lines BL₀ - BL₂ to OPEN (i.e. turning OFF the n-MOS transistors 612₀ - 612₂), or by setting the source line SL to a high voltage, e.g. 12V, the word lines WL₀ to WL₂ to 0 V, and the bit lines BL₀ - BL₂ to OPEN.

Next, erase verification is carried out (step B4). This operation is carried out by setting the word lines WL₀ - WL₂ to VCC, the source line SL to VCC, turning ON the n-MOS transistors 612₀ - 612₂ and 629 (gate voltage = VCC + Vₜₕ₋ₙ), and comparing the voltage value of the data bus 613 with the voltage value of the reference voltage V_{ref}.

In this case, the voltage of the data bus 613 coincides with the drain voltage of the memory cell transistors M11₀₀ to M11₂₂, and the voltage of the data bus 613 is the difference obtained by subtracting from the voltage (VCC) applied to the word lines the threshold value of the memory cell transistor having the highest erase rate among n-MOS transistors M11₀₀-M11₂₂ (the threshold value of the memory cell transistor which has the minimum threshold value within the above-mentioned range).

In the next step B5, it is judged whether or not the judgement output obtained at the judgement output terminal 630 is "H". When the judgement output is not "H" (NO at step B5) (that is, when the voltage of the data bus 613 < the reference voltage Vref) the threshold value of the memory cell transistor having the highest erase rate among the memory cell transistors M11₀₀ - M11₂₂ is higher than the allowed lower limit threshold value Vth.

In this case, because of variations in the cell-transistor characteristics there is the possibility that there exists a memory cell transistor which exhibits a greater threshold value than the post-erasure threshold value (allowed upper limit threshold value) required of the memory cell transistor having the highest erase time (slowest erase rate). Therefore, the flow returns to the step B2, and erase is carried out once again.

In contrast, when the judgement output obtained at the judgement output terminal 630 is "H" (YES at step B5) (that is, when the voltage of the data bus 613 ≥ the reference voltage Vref) the threshold value of the memory cell transistor having the highest erase rate among the memory cell transistors M11₀₀ - M11₂₂ has reached the allowed lower limit threshold value.

In this case, the threshold value of the memory cell transistor having the lowest erase rate can be assumed to have reached the allowed upper limit threshold value, but it is not possible to exclude the possibility that, due to defects, there exists one or more memory cell transistors having a greater threshold value than the allowed upper limit threshold value.

In the first embodiment, therefore, even in the case of YES at the step B5, the output of the sense amplifier 608 is judged (step B6) by carrying out erase verification according to the prior art method. In other words, the memory cell transistors M11₀₀ to M11₂₂ are read one by one, and it is judged in step B7 whether or not any memory cell transistor renders the output of the sense amplifier 608 "H" (that is, whether or not there exists a memory cell transistor which exhibits a greater threshold value than the allowed upper limit threshold value).

When no memory cell transistor exists which renders the output of the sense amplifier 608 "H" (NO at step B7), the erasing operation is completed on the presumptions that the device is not a defective device and that erasure has been completed for all the memory cell transistors M11₀₀ to M11₂₂.

In contrast, when there does exist a memory cell transistor which renders the output of the sense amplifier 608 "H" (YES at step B7), the device is treated as a defective device (step B8).

As described above, the first embodiment sets the reference potential in accordance with the post-erasure threshold value required of the memory cell transistor having the highest erase rate (that is, the allowed lower limit threshold value) and confirms that the threshold value of the memory cell transistor having the highest erase rate has reached the allowed lower limit threshold value using the reference potential, and then confirms the absence of any memory cell transistor rendering the output of the sense amplifier 608 "H". The first embodiment can thus complete the erasing operation.

Here, whether or not the threshold value of the memory cell transistor having the highest erase time reaches the allowed lower limit threshold value can be confirmed by setting the word lines WL₀ - WL₂ to VCC, the source line SL to VCC and the gates of the n-MOS transistors 612₀ - 612₂ and 629 to VCC + Vₜₕ₋ₙ. In this case, it is not necessary to read the memory cell transistors M11₀₀ - M11₂₂ one by one.

Incidentally, when a voltage above VCC + Vₜₕ₋ₙ is applied to the gates of the n-MOS transistors 612₀ - 612₂ and 629, the voltage drop of these n-MOS transistors 612₀ to 612₂ and 629 can be neglected.

The judgement of the existence or absence of the memory cell transistor rendering the output of the output for the sense amplifier 608 "H" can be accomplished by carrying out the erase verify of the prior art method only once.

This first embodiment can execute erase verify by detecting the case where the memory cell transistor having the highest erase rate reaches the allowed lower limit threshold value. Accordingly, over-erased memory cell transistors are not caused.

Accordingly, the first embodiment can shorten the erase verify time as well as the time necessary for erase, and can execute erase without generating over-erased memory cell transistors.

In this first embodiment, erase verification may also be executed for those memory cell transistors which share a common bit line (i.e. one erase verification per bit line), or for each memory cell transistor (i.e. one erase verification per cell transistor).

When erase verification is carried out for those memory cell transistors which share a bit line in common, for example when erase verification is simultaneously executed for the memory cell transistors M11ₒₒ, M11₁₀ and M11₂₀ connected to the bit line BLₒ, for example, this operation can be carried out by setting the word lines WLₒ - WL₂ to VCC, the source line SL to VCC, turning ON the n-MOS transistors 612₀ and 629 (gate voltage = VCC + Vₜₕ₋ₙ), and turning OFF the n-MOS transistors 612₁ and 612₂ (gate voltage = ground potential VSS).

Erase verification can be executed for an individual memory cell transistor such as the memory cell transistor M11ₒₒ by setting the word line WLₒ to VCC, the word lines WL₁ and WL₂ to VSS, and the source line SL to VCC, turning ON the n-MOS transistors 612ₒ and 629 (gate voltage = VCC + Vₜₕ₋ₙ) and turning OFF the n-MOS transistors 612₁ and 612₂ (gate voltage = VSS).

In this first embodiment, VCC + V_{ch-n} is applied to the gates of the n-MOS transistors 612ₒ - 612₂ and 629 when these transistors are turned ON, but VCC may also be applied.

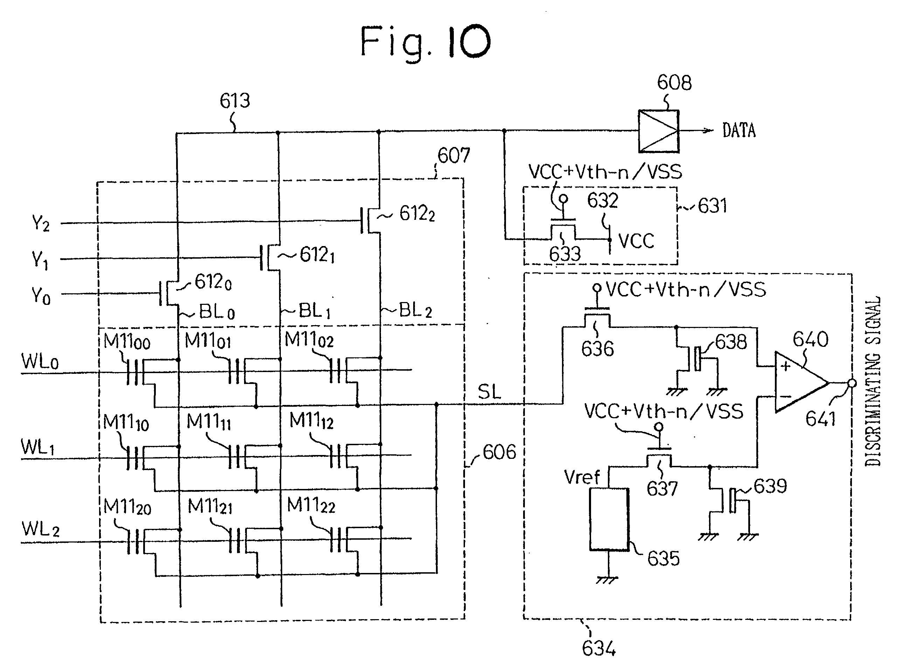

Fig. 10 is a circuit diagram showing portions of a second embodiment of the present invention. In this second embodiment, there is disposed a voltage supply circuit 631 for supplying the power supply voltage VCC to the data bus 613 at the time of erase verify.

Reference numeral 632 denotes the VCC power supply line, and reference numeral 633 denotes an n-MOS transistor. At the time of erase verify, VCC + Vₜₕ₋ₙ is applied to the gate of this n-MOS transistor 633 to turn ON this transistor, and VSS is applied to the gate at other times to turn the transistor OFF.

There is also disposed a voltage judgement circuit 634 which judges whether or not the voltage of the source line SL is greater than the difference obtained by subtracting the allowed lower limit threshold value of the memory cell transistors M11ₒₒ - M11₂₂ from VCC at the time of erase verify. The rest of the construction is the same as that of the prior art flash memory shown in Fig. 1.

In this voltage judgement circuit 634, reference numeral 635 denotes a reference voltage generation circuit for generating a reference voltage Vref, and this reference voltage Vref is set to the difference obtained by subtracting from VCC the allowed lower limit threshold value of the memory cell transistors M11₀₀ - M11₂₂.

Reference numerals 636 and 637 denote enhancement type n-MOS transistors having the same size and constituting a gating circuit, reference numerals 638 and 639 denote depletion type n-MOS transistors having the same size and constituting respective load circuits, reference numeral 640 denotes an operational amplifier, and reference numeral 641 denotes a judgement output terminal which outputs a judgement result.

The n-MOS transistors 636 and 637 are turned ON at the time of erase verify as VCC + Vₜₕ₋ₙ is applied to their gates, and are turned OFF at other times as VSS is applied to their gates.

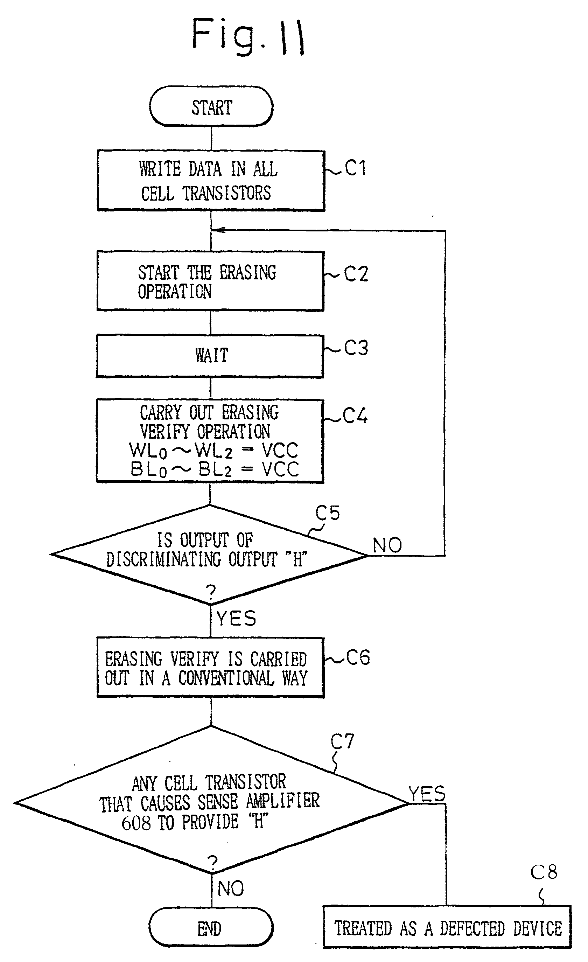

In this second embodiment the erasing operation is carried out in the same way as in the first embodiment. In other words, the post-erasure threshold value required of the memory cell transistor having the highest erase rate, that is, the allowed lower limit threshold value, is used to set the reference voltage Vref, and it is confirmed using the reference voltage Vref whether or not the threshold value of the memory cell transistor having the highest erase rate has reached the allowed lower limit threshold value. Then, erase verification is executed by the prior art method. More definitely, this operation is carried out in the sequence shown in Fig. 11.

First of all, write to all the memory cell transistors M11₀₀ - M11₂₂ is carried out (step C1). Next, after the erasing operation is started, a wait state (the erasing operation holding state) is held for a predetermined waiting time (steps C2 and C3).

Here, the erasing operation is carried out by setting the source line SL to VCC, the word lines WL₀ - WL₂ to a negative potential and the bit lines BL₀ - BL₂ to OPEN (i.e. turning OFF the n-MOS transistors 612₀ - 612₂), or by setting the source line SL to a high voltage, e.g. 12V, the word lines WL₀ - WL₂ to 0 V, and the bit lines BL₀ - BL₂ to OPEN.

Next, erase verify is executed (step C4). This operation is carried out by turning ON the n-MOS transistors 612₀ - 612₂, 633, 636 and 637 (the gate voltage = VCC + Vₜₕ₋ₙ), setting the bit lines BL₀ - BL₂ to VCC and the word lines WL₀ - WL₂ to VCC, and comparing the voltage value of the source line SL with the reference voltage Vref.

At this time, the source voltage of the memory cell transistors M11₀₀ - M11₂₂, that is, the voltage of the source line SL, becomes equal to the potential difference between VCC and the threshold voltage of the memory cell transistor having the highest erase rate (the threshold value of the memory cell transistor having the minimum threshold value).

Here, it is judged whether or not the judgement output obtained at the judgement output terminal 641 is "H" (step C5). When the judgement output is not "H" (NO at step C5), that is, when the voltage of the source line SL < the reference voltage Vref, the threshold voltage of the memory cell transistor having the highest erase rate is higher than the allowed lower limit threshold value.

In this case, because of cell-transistor characteristic variations there is a possibility that there is a memory cell transistor exhibiting a greater post-erasure threshold value than the allowed upper limit threshold value (i.e. the threshold value required of the memory cell transistor having the highest erase time (the slowest erasure rate)). Therefore, the flow returns to the step C2, and the erasing operation is carried out once again.

In contrast, when the judgement output obtained at the judgement output terminal 641 is "H" (YES at the step C5), that is, when the voltage of the source line SL ≥ the reference voltage Vref, the threshold value of the memory cell transistor having the highest erase rate among the memory cell transistor M11₀₀ - M11₂₂ has reached the allowed lower limit threshold value.

In this case, the threshold value of the memory cell transistor having the lowest erasure rate can be assumed to have reached the allowed upper limit threshold value. However, it is not possible to exclude the possibility that there exists one or more defective memory cells which have a greater threshold value than the allowed upper limit threshold value.

In this second embodiment, therefore, it is judged (even in the case of YES at the step C5) whether or not there exists a memory cell transistor which renders the output of the sense amplifier 608 "H", that is, which exhibits a greater threshold value than the allowed upper limit threshold value. This is done by effecting the erase verify by the prior art method or, in other words, by bringing the memory cell transistors M11₀₀ - M11₂₂ into the read state one by one and by judging the output of the sense amplifier 608 (steps C6 and C7).

If none of memory cell transistors renders the output of the sense amplifier 608 "H" (NO at the step C7), the device is not a defective device, and the erasing operation is completed on the presumption that all of the memory cell transistors M11₀₀ - M11₂₂ have been erased.

In contrast, when any memory cell transistor renders the output of the sense amplifier 608 "H" (YES at the step C7), the device is treated as a defective device (step C8).

As described above, the second embodiment uses the post-erasure threshold value required of the memory cell transistor having the highest erase rate, that is, the allowed lower limit threshold value, to set the reference potential, confirms using the reference potential whether or not the threshold value of the memory cell transistor having the highest erase rate reaches the allowed lower limit threshold value, confirms also whether or not there exists a memory cell transistor which renders the output of the sense amplifier 608 "H", and can thus complete the erasing operation.

In this case, it can be confirmed whether or not the threshold value of the memory cell transistor having the highest erase rate has reached the reference potential by setting the word lines WL₀ - WL₂ to VCC and the bit lines BL₀ - BL₂ to VCC and turning ON the transistors 612₀ - 612₂, 633, 636 and 637 (gate voltage = VCC + Vₜₕ₋ₙ). The memory cell transistors M11₀₀ - M11₂₂ need not be brought into the read state one by one.

Judgement of whether or not any memory cell transistor renders the output of the sense amplifier 608 "H" is carried out by executing erase verification by the prior art method only once for all the memory cell transistors M11₀₀ - M11₂₂.

Since this second embodiment can execute erase verification by detecting the case where the memory cell transistor having the highest erase rate has reached the allowed lower limit threshold value, over-erasure of memory cell transistors is not caused.

Accordingly, this second embodiment can shorten the erase verify time and the time necessary for the erasing operation. Moreover, it can execute the erasing operation without causing the over-erased memory cell transistors.

In this second embodiment, erase verification may also be executed for each set in turn of memory cell transistors which share a common bit line, or for each memory cell transistor in turn.

When erase verification is executed for a set of memory cell transistors which have a bit line in common, the memory cell transistors M11₀₀, M11₁₀ and M11₂₀ connected to the bit line BL₀, for example, can be subjected simultaneously to erase verification by setting the word lines WL₀ - WL₂ to VCC, turn ON the n-MOS transistors 612₀, 633, 636 and 637 (gate voltage = VCC + Vₜₕ₋ₙ) and turning off the n-MOS transistors 612₁ to 612₂ (gate voltage = VSS).

When erase verification is executed individually for each memory cell transistor such as the memory cell transistor M11₀₀, for example, it can be carried out by setting the word lines WL₀ to VCC and the word lines WL₁ and WL₂ to VSS, turning ON the n-MOS transistors 612₀, 633, 636 and 637 (gate voltage = VCC + Vₜₕ₋ₙ) and turning OFF the n-MOS transistors 612₁ and 612₂ (gate voltage = VSS).

Incidentally, in this second embodiment, VCC + Vₜₕ₋ₙ is applied to the gates of the n-MOS transistors 612₀ - 612₂, 636 and 637 when these transistors are turned ON, but VCC may also be applied.

As described above, an embodiment of the present invention can simultaneously execute erase verification for a plurality of memory cell transistors, and since all the memory cell transistors need not be read out one by one, this embodiment can shorten the erase verify time and the time necessary for the erasing operation. Since this embodiment executes erase verification by detecting the point of time when the threshold value of the memory cell transistor having the highest erase rate has reached the allowed lower limit threshold value, the erasing operation can be carried out without causing any over-erased memory cell transistors.

As described above, in one embodiment of the present invention a flash-type memory has a cell matrix circuit 1 in which erasable nonvolatile memory cells Mij are disposed at the intersections of a plurality of word lines WL1 to WLm. The memory further includes a plurality of bit lines BL11 to BL1k, ..., BLn1 to BLnk, a row decoder circuit 3, a column decoder circuit 5 and sense amplifier circuits connected to the bit groups BL11 to BL1k, ..., BLn1 to BLnk of the cell matrix circuit 1. All the cell transistors forming together the cell matrix circuit are connected parallel to each other with the transistors remaining conductive. The cell matrix circuit has connected thereto a voltage judgement means composed of a means of detecting a voltage developed in response to a current flowing through all of the cell transistors, a reference voltage generating means, and a means of comparing the voltage output from the voltage detecting means with a reference voltage delivered from the reference voltage generating means.

## Claims

1. A nonvolatile semiconductor memory device including: a matrix (1) of nonvolatile erasable memory cells (M11) formed at intersections of word lines (WL) and bit lines (BL), each said memory cell comprising a memory cell transistor; a row decoder (3); a column decoder (5); sense amplifiers (7) corresponding to the bit lines; and erase verification means (623, 624; 633, 634) operable, following an erase operation on a plurality of the said memory cells of the matrix, to carry out an erase verify operation to verify that each cell of the said plurality has been erased sufficiently;
**characterised in that** the said erase verification means comprise:
threshold voltage measuring means (623, 626; 631, 636, 638) connected with the memory cells of the said plurality and operable to produce, for an individual one of those memory cells or for a set (605; 606) of those memory cells, a measurement signal that, in the case of an individual memory cell, is representative of a threshold voltage of the said memory cell transistor of the individual memory cell or that, in the case of a set, is representative of a threshold voltage of the said memory cell transistor of that cell of the set having the highest erasure rate;
reference signal generating means (628; 635) for producing a reference signal (Vref) representative of a predetermined highest-erasure-rate threshold voltage, being the post-erasure threshold voltage required of that cell of the matrix having the highest erasure rate; and
comparison means (625; 640) for comparing the or each said measurement signal with the said reference signal and for judging, based on the comparison(s), whether the threshold voltage of any one of the memory cells of the said plurality has reached the said predetermined highest-erasure-rate threshold voltage.

2. A device as claimed in claim 1, wherein the said predetermined highest-erasure-rate threshold voltage is chosen such that, when the threshold voltage of the said cell of the matrix having the highest erasure rate has reached the said predetermined highest-erasure-rate threshold voltage, a non-defective cell of the matrix having the lowest erasure rate will have been erased sufficiently.

3. A device as claimed in claim 1 or 2, wherein, to produce the said measurement signal for such a set (605; 606), the said threshold voltage measuring means are operable to make the respective memory cell transistors of the cells of the set conductive so that a current path is formed in each transistor between respective first and second current-path terminals thereof, and are also operable to connect the respective memory cell transistors of the cells of the set in parallel with one another such that the respective first current-path terminals thereof are connected together to a first connection line (SL) and the respective second current-path terminals thereof are connected together to a second connection line (613), the said measurement signal being derived from one (613; SL) of the said first and second connection lines.

4. A device as claimed in claim 3, wherein the cells of the said set are arranged along the same bit line or along the same group of bit lines (BL0 to BL2).

5. A device as claimed in claim 3 or 4, wherein the cells of the said set are arranged along the same word line or along the same group of word lines (WL0 to WL2).

6. A device as claimed in claim 1 or 2, wherein, to produce the said measurement signal for an individual memory cell, the said threshold voltage measuring means are operable to make the memory cell transistor of the cell conductive so that a current path is formed in that transistor between respective first and second current-path terminals thereof, and are also operable to connect the first and second current-path terminals thereof respectively to first and second connection line (SL, 613) of the device, the said measurement signal being derived from one (613; SL) of the said first and second connection lines.

7. A device as claimed in any one of claims 3 to 6, wherein a predetermined voltage (VCC) is applied to a control electrode of the memory cell transistor of the said individual memory cell, or of the said memory cell transistor of each cell of the said set, as the case may be.

8. A device as claimed in claim 7, wherein the said measurement signal represents a difference between the said predetermined voltage (VCC) and the threshold voltage of the said individual memory cell or highest-erasure-rate memory cell of the set.

9. A device as claimed in claim 7 or 8, wherein the said reference signal represents a difference between the said predetermined voltage (VCC) and the said predetermined highest-erasure-rate threshold voltage.

10. A device as claimed in any one of claims 7 to 9, wherein the said predetermined voltage is a normal supply voltage (VCC) of the device.

11. A device as claimed in any one of claims 3 to 10, wherein the said first current-path terminal of the or each memory cell transistor is a source terminal and the said second current-path terminal of the or each memory cell transistor is a drain terminal thereof.

12. A device as claimed in claim 11, wherein the said first connection line (SL) is a source line connected in common to respective source terminals of the memory cell transistors of all of the memory cells of the said plurality, and the said second connection line (613) is a data bus of the device serving to connect one or more bit lines (BL) to one of the said sense amplifiers (608).

13. A device as claimed in any preceding claim, further including erase means operable, in the event that it is determined that none of the said memory cells of the said plurality has reached the said predetermined highest-erasure-rate threshold voltage, to cause a further such erase operation to be performed on the memory cells of the said plurality.

14. A device as claimed in any preceding claim, further comprising:
defect detection means operable, following such a judgement by the said comparison means (625; 640) that the threshold voltage of one of the said memory cells of the said plurality has reached the said predetermined highest-erasure-rate threshold voltage, to carry out a further verification operation in which it is determined individually, for each memory cell of the said plurality, whether the threshold voltage has reached a predetermined lowest-erasure-rate threshold voltage, being the threshold voltage required of that cell of the matrix having the lowest erasure rate, and, if not, the cell concerned is determined as being defective.

15. An erase verification method, for use in a nonvolatile semiconductor memory that includes: a matrix (1) of nonvolatile erasable memory cells (M11) formed at intersections of word lines (WL) and bit lines (BL), each said memory cell comprising a memory cell transistor; a row decoder (3); a column decoder (5); and sense amplifiers (608) corresponding to the bit lines; which method comprises the steps of:
following an erase operation on a plurality of the said memory cells of the matrix, producing, for an individual one of those memory cells or for a set (605; 606) of those memory cells, a measurement signal that, in the case of an individual memory cell, is representative of a threshold voltage of the said memory cell transistor of the individual memory cell or that, in the case of a set, is representative of a threshold voltage of the said memory cell transistor of that cell of the set having the highest erasure rate;
producing a reference signal representative of a predetermined highest-erasure-rate threshold voltage, being the post-erasure threshold voltage required of that cell of the matrix having the highest erasure rate; and
comparing the or each said measurement signal with the said reference signal and judging, based on the comparison(s), whether the threshold voltage of any one of the memory cells of the said plurality has reached the predetermined highest-erasure-rate threshold voltage.

16. A method as claimed in claim 15, wherein, in the event that it is determined that none of the said memory cells of the said plurality has reached the said predetermined highest-erasure-rate threshold voltage, a further such erase operation is caused to be performed on the memory cells of the said plurality.

17. A method as claimed in claim 15 or 16, wherein, following such a judgement that the threshold voltage of one of the said memory cells of the said plurality has reached the said predetermined highest-erasure-rate threshold voltage, a further verification operation is carried out in which it is determined individually, for each memory cell of the said plurality, whether the threshold voltage has reached a predetermined lowest-erasure-rate threshold voltage, being the threshold voltage required of that cell of the matrix having the lowest erasure rate, and, if not, the cell concerned is determined as being defective.

18. A nonvolatile semiconductor memory having a matrix (1) of nonvolatile erasable memory cells (Mij) formed at intersections of word lines (WL1 to WLm) and bit lines (BL11 to BL1k, ..., BLn1 to BLnk), a row decoder (3), a column decoder (5), sense amplifiers (7) connected to the bit lines (BL11 to BL1k, ..., BLn1 to BLnk) respectively, and voltage determination means connected to the matrix, **characterized in that** said voltage determination means comprises:
voltage detection means (3, 8, 9, 612, 613) for making all memory cell transistors of the matrix conductive and connecting them in parallel with one another to detect a voltage produced by a current flowing through the memory cell transistors;
reference voltage generation means (628); and
comparison means (625) for comparing an output voltage (613) of the voltage detection means with a reference voltage provided by the reference voltage generation means (628).

19. The nonvolatile semiconductor memory according to claim 18, wherein:
a predetermined voltage is applied to a source line connecting all the sources of the memory cell transistors together,
the same or different positive voltages are applied to the source line and all or part of word lines that form control gates of the memory cell transistors,
the drains of the cell transistors are connected to a data bus, and
the voltage determination means is connected to the data bus.

20. The nonvolatile semiconductor memory according to claim 18, wherein:
the sources of the memory cell transistors are connected to a single source line,
the drains of the cell transistors are commonly connected to a data bus,
the same or different positive voltages are applied to the data bus and all or some of word lines that form the control gates of the memory cell transistors, and
the voltage determination means is connected to the source line.

## Patentansprüche

1. Nichtflüchtige Halbleiterspeichervorrichtung mit: einer Matrix (1) aus nichtflüchtigen löschbaren Speicherzellen (M11), die an Schnittpunkten von Wortleitungen (WL) und Bitleitungen (BL) gebildet sind, wobei jede Speicherzelle einen Speicherzellentransistor umfaßt; einem Reihendecodierer (3); einem Spaltendecodierer (5); Leseverstärkern (7), die den Bitleitungen entsprechen; und einem Löschverifizierungsmittel (623, 624; 633, 634), das im Anschluß an eine Löschoperation an einer Vielzahl der Speicherzellen der Matrix betriebsfähig ist, um eine Löschverifizierungsoperation auszuführen, um zu verifizieren, daß jede Zelle von der Vielzahl hinreichend gelöscht worden ist;
**dadurch gekennzeichnet, daß** das Löschverifizierungsmittel umfaßt:
ein Schwellenspannungsmeßmittel (623, 626; 631, 636, 638), das mit den Speicherzellen von der Vielzahl verbunden ist und betriebsfähig ist, um für eine individuelle von jenen Speicherzellen oder für einen Satz (605; 606) von jenen Speicherzellen ein Meßsignal zu erzeugen, das im Falle einer individuellen Speicherzelle für eine Schwellenspannung des Speicherzellentransistors der individuellen Speicherzelle repräsentativ ist oder im Falle eines Satzes für eine Schwellenspannung des Speicherzellentransistors von jener Zelle des Satzes repräsentativ ist, die die höchste Löschrate hat;
ein Referenzsignalerzeugungsmittel (628, 635) zum Erzeugen eines Referenzsignals (Vref), das für eine vorbestimmte Schwellenspannung der höchsten Löschrate repräsentativ ist, die die Nachlöschschwellenspannung ist, die von jener Zelle der Matrix verlangt wird, die die höchste Löschrate hat; und
ein Vergleichsmittel (625; 640) zum Vergleichen des oder jedes genannten Meßsignals mit dem Referenzsignal und zum Beurteilen auf der Basis des Vergleichs (der Vergleiche), ob die Schwellenspannung von irgendeiner der Speicherzellen von der Vielzahl die vorbestimmte Schwellenspannung der höchsten Löschrate erreicht hat.

2. Vorrichtung nach Anspruch 1, bei der die vorbestimmte Schwellenspannung der höchsten Löschrate so gewählt wird, daß dann, wenn die Schwellenspannung von der Zelle der Matrix, die die höchste Löschrate hat, die vorbestimmte Schwellenspannung der höchsten Löschrate erreicht hat, eine nichtdefekte Zelle der Matrix, die die niedrigste Löschrate hat, hinreichend gelöscht worden sein wird.

3. Vorrichtung nach Anspruch 1 oder 2, bei der zum Erzeugen des Meßsignals für solch einen Satz (605; 606) das Schwellenspannungsmeßmittel betriebsfähig ist, um die jeweiligen Speicherzellentransistoren der Zellen des Satzes leitfähig zu machen, so daß ein Stromweg in jedem Transistor zwischen seinen jeweiligen ersten und zweiten Stromweganschlüssen gebildet wird, und ferner betriebsfähig ist, um die jeweiligen Speicherzellentransistoren der Zellen des Satzes parallel miteinander zu verbinden, so daß ihre jeweiligen ersten Stromweganschlüsse zusammen mit einer ersten Verbindungsleitung (SL) verbunden sind und ihre jeweiligen zweiten Stromweganschlüsse zusammen mit einer zweiten Verbindungsleitung (613) verbunden sind, welches Meßsignal von einer (613; SL) der ersten und zweiten Verbindungsleitungen erhalten wird.

4. Vorrichtung nach Anspruch 3, bei der die Zellen des Satzes längs derselben Bitleitung oder längs derselben Gruppe von Bitleitungen (BL0 bis BL2) angeordnet sind.

5. Vorrichtung nach Anspruch 3 oder 4, bei der die Zellen des Satzes längs derselben Wortleitung oder längs derselben Gruppe von Wortleitungen (WL0 bis WL2) angeordnet sind.

6. Vorrichtung nach Anspruch 1 oder 2, bei der zum Erzeugen des Meßsignals für eine individuelle Speicherzelle das Schwellenspannungsmeßmittel betriebsfähig ist, um den Speicherzellentransistor der Zelle leitfähig zu machen, so daß ein Stromweg in jenem Transistor zwischen seinen jeweiligen ersten und zweiten Stromweganschlüssen gebildet wird, und ferner betriebsfähig ist, um seine ersten und zweiten Stromweganschlüsse jeweilig mit ersten und zweiten Verbindungsleitungen (SL, 613) der Vorrichtung zu verbinden, welches Meßsignal von einer (613; SL) der ersten und zweiten Verbindungsleitungen erhalten wird.

7. Vorrichtung nach irgendeinem der Ansprüche 3 bis 6, bei der eine vorbestimmte Spannung (VCC) auf eine Steuerelektrode des Speicherzellentransistors der individuellen Speicherzelle oder des Speicherzellentransistors von jeder Zelle des Satzes, je nachdem, angewendet wird.

8. Vorrichtung nach Anspruch 7, bei der das Meßsignal eine Differenz zwischen der vorbestimmten Spannung (VCC) und der Schwellenspannung von der individuellen Speicherzelle oder von der Speicherzelle mit der höchsten Löschrate des Satzes repräsentiert.

9. Vorrichtung nach Anspruch 7 oder 8, bei der das Referenzsignal eine Differenz zwischen der vorbestimmten Spannung (VCC) und der vorbestimmten Schwellenspannung der höchsten Löschrate repräsentiert.

10. Vorrichtung nach irgendeinem der Ansprüche 7 bis 9, bei der die vorbestimmte Spannung eine normale Zufuhrspannung (VCC) der Vorrichtung ist.

11. Vorrichtung nach irgendeinem der Ansprüche 3 bis 10, bei der der erste Stromweganschluß des oder jedes Speicherzellentransistors ein Sourceanschluß ist und der zweite Stromweganschluß des oder jedes Speicherzellentransistors ein Drainanschluß von ihm ist.

12. Vorrichtung nach Anspruch 11, bei der die erste Verbindungsleitung (SL) eine Sourceleitung ist, die mit jeweiligen Sourceanschlüssen der Speicherzellentransistoren von allen Speicherzellen von der Vielzahl gemeinsam verbunden ist, und die zweite Verbindungsleitung (613) ein Datenbus der Vorrichtung ist, der dazu dient, eine oder mehrere Bitleitungen (BL) mit einem der Leseverstärker (608) zu verbinden.

13. Vorrichtung nach irgendeinem vorhergehenden Anspruch, ferner mit einem Löschmittel, das betriebsfähig ist, falls bestimmt wird, daß keine der Speicherzellen von der Vielzahl die vorbestimmte Schwellenspannung der höchsten Löschrate erreicht hat, um das Ausführen einer weiteren derartigen Löschoperation an den Speicherzellen von der Vielzahl zu bewirken.

14. Vorrichtung nach irgendeinem vorhergehenden Anspruch, ferner mit:
einem Defektdetektionsmittel, das im Anschluß an solch eine Beurteilung durch das Vergleichsmittel (625; 640), daß die Schwellenspannung von einer der Speicherzellen von der Vielzahl die vorbestimmte Schwellenspannung der höchsten Löschrate erreicht hat, betriebsfähig ist, um eine weitere Verifizierungsoperation auszuführen, bei der für jede Speicherzelle von der Vielzahl individuell bestimmt wird, ob die Schwellenspannung eine vorbestimmte Schwellenspannung der niedrigsten Löschrate erreicht hat, welche die Schwellenspannung ist, die von jener Zelle der Matrix verlangt wird, die die niedrigste Löschrate hat, und, falls nicht, bestimmt wird, daß die betreffende Zelle defekt ist.

15. Löschverifizierungsverfahren zur Verwendung in einem nichtflüchtigen Halbleiterspeicher, der enthält: eine Matrix (1) aus nichtflüchtigen löschbaren Speicherzellen (M11), die an Schnittpunkten von Wortleitungen (WL) und Bitleitungen (BL) gebildet sind, wobei jede Speicherzelle einen Speicherzellentransistor umfaßt; einen Reihendecodierer (3); einen Spaltendecodierer (5); und Leseverstärker (608), die den Bitleitungen entsprechen; welches Verfahren die folgenden Schritte umfaßt:
Erzeugen eines Meßsignals, im Anschluß an eine Löschoperation an einer Vielzahl der Speicherzellen der Matrix, für eine individuelle von jenen Speicherzellen oder für einen Satz (605; 606) von jenen Speicherzellen, das im Falle einer individuellen Speicherzelle für eine Schwellenspannung des Speicherzellentransistors der individuellen Speicherzelle repräsentativ ist oder im Falle eines Satzes für eine Schwellenspannung des Speicherzellentransistors von jener Zelle des Satzes repräsentativ ist, die die höchste Löschrate hat;
Erzeugen eines Referenzsignals, das für eine vorbestimmte Schwellenspannung der höchsten Löschrate repräsentativ ist, welche die Nachlöschschwellenspannung ist, die von jener Zelle der Matrix verlangt wird, die die höchste Löschrate hat; und
Vergleichen des oder jedes Meßsignals mit dem Referenzsignal und Beurteilen, auf der Basis des Vergleichs (der Vergleiche), ob die Schwellenspannung von irgendeiner der Speicherzellen von der Vielzahl die vorbestimmte Schwellenspannung der höchsten Löschrate erreicht hat.

16. Verfahren nach Anspruch 15, bei dem dann, falls bestimmt wird, daß keine der Speicherzellen von der Vielzahl die vorbestimmte Schwellenspannung der höchsten Löschrate erreicht hat, das Ausführen einer weiteren derartigen Löschoperation an den Speicherzellen von der Vielzahl bewirkt wird.

17. Verfahren nach Anspruch 15 oder 16, bei dem im Anschluß an solch eine Beurteilung, daß die Schwellenspannung von einer der Speicherzellen von der Vielzahl die vorbestimmte Schwellenspannung der höchsten Löschrate erreicht hat, eine weitere Verifizierungsoperation ausgeführt wird, bei der für jede Speicherzelle von der Vielzahl individuell bestimmt wird, ob die Schwellenspannung eine vorbestimmte Schwellenspannung der niedrigsten Löschrate erreicht hat, welche die Schwellenspannung ist, die von jener Zelle der Matrix verlangt wird, die die niedrigste Löschrate hat, und, falls nicht, bestimmt wird, daß die betreffende Zelle defekt ist.

18. Nichtflüchtiger Haibleiterspeicher mit einer Matrix (1) aus nichtflüchtigen löschbaren Speicherzellen (Mij), die an Schnittpunkten von Wortleitungen (WL1 bis WLm) und Bitleitungen (BL11 bis BL1k, ..., BLn1 bis BLnk) gebildet sind, einem Reihendecodierer (3), einem Spaltendecodierer (5), Leseverstärkern (7), die jeweilig mit den Bitleitungen (BL11 bis BL1k, ..., BLn1 bis BLnk) verbunden sind, und einem Spannungsbestimmungsmittel, das mit der Matrix verbunden ist, **dadurch gekennzeichnet, daß** das Spannungsbestimmungsmittel umfaßt:
ein Spannungsdetektionsmittel (3, 8, 9, 612, 613), um alle Speicherzellentransistoren der Matrix leitfähig zu machen und sie parallel miteinander zu verbinden, um eine Spannung zu detektieren, die durch einen Strom erzeugt wird, der durch die Speicherzellentransistoren fließt;
ein Referenzspannungserzeugungsmittel (628); und
ein Vergleichsmittel (625) zum Vergleichen einer Ausgangsspannung (613) des Spannungsdetektionsmittels mit einer Referenzspannung, die durch das Referenzspannungserzeugungsmittel (628) vorgesehen wird.

19. Nichtflüchtiger Halbleiterspeicher nach Anspruch 18, bei dem:
eine vorbestimmte Spannung auf eine Sourceleitung angewendet wird, die alle Sources der Speicherzellentransistoren zusammen verbindet,
dieselben oder verschiedene positive Spannungen auf die Sourceleitung und alle oder einen Teil der Wortleitungen, die Steuergates der Speicherzellentransistoren bilden, angewendet werden,
die Drains der Zellentransistoren mit einem Datenbus verbunden sind und
das Spannungsbestimmungsmittel mit dem Datenbus verbunden ist.

20. Nichtflüchtiger Halbleiterspeicher nach Anspruch 18, bei dem:
die Sources der Speicherzellentransistoren mit einer einzelnen Sourceleitung verbunden sind,
die Drains der Zellentransistoren gemeinsam mit einem Datenbus verbunden sind,
dieselben oder verschiedene positive Spannungen auf den Datenbus und alle oder einige der Wortleitungen, die die Steuergates der Speicherzellentransistoren bilden, angewendet werden und
das Spannungsbestimmungsmittel mit der Sourceleitung verbunden ist.

## Revendications

1. Un dispositif de mémoire non volatile à semiconducteur comprenant : une matrice (1) de cellules de mémoire effaçable non volatile (M11) formées à des intersections de conducteurs de mot (WL) et de conducteurs de bits (BL), chaque cellule de mémoire comprenant un transistor de cellule de mémoire; un décodeur de ligne (3); un décodeur de colonne (5); des amplificateurs de lecture (7) correspondant aux conducteurs de bit; et des moyens de vérification d'effacement (623, 624; 633, 634) qu'on peut faire fonctionner, à la suite d'une opération d'effacement sur une multiplicité des cellules de mémoire de la matrice, pour accomplir une opération de vérification d'effacement de façon à vérifier que chaque cellule de la multiplicité a été suffisamment effacée;
**caractérisé en ce que** les moyens de vérification d'effacement comprennent :
des moyens de mesure de tension de seuil (623, 626; 631, 636, 638) connectés aux cellules de mémoire de ladite multiplicité et qu'on peut faire fonctionner pour produire, pour l'une individuelle de ces cellules de mémoire ou pour un ensemble (605; 606) de ces cellules de mémoire, un signal de mesure qui, dans le cas d'une cellule de mémoire individuelle, est représentatif d'une tension de seuil du transistor de cellule de mémoire de la cellule de mémoire individuelle, ou qui, dans le cas d'un ensemble, est représentatif d'une tension de seuil du transistor de cellule de mémoire de la cellule de l'ensemble ayant la vitesse d'effacement la plus élevée;
des moyens de génération de signal de référence (628; 635) pour produire un signal de référence (Vref) représentatif d'une tension de seuil prédéterminée pour la vitesse d'effacement la plus élevée, qui est la tension de seuil après effacement exigée pour la cellule de la matrice ayant la vitesse d'effacement la plus élevée; et
des moyens de comparaison (625; 640) pour comparer le signal de mesure, ou chacun d'eux, avec le signal de référence, et pour déterminer, sur la base de la comparaison ou des comparaisons, si la tension de seuil de l'une quelconque des cellules de mémoire dudit ensemble a atteint la tension de seuil prédéterminée pour la vitesse d'effacement la plus élevée.

2. Un dispositif selon la revendication 1, dans lequel la tension de seuil prédéterminée pour la vitesse d'effacement la plus élevée est choisie de façon que, lorsque la tension de seuil de la cellule de la matrice ayant la vitesse d'effacement la plus élevée a atteint la tension de seuil prédéterminée pour la vitesse d'effacement la plus élevée, une cellule non défectueuse de la matrice ayant la vitesse d'effacement la plus basse aura été effacée suffisamment.

3. Un dispositif selon la revendication 1 ou 2, dans lequel, pour produire le signal de mesure pour un tel ensemble (605; 606), on peut faire fonctionner les moyens de mesure de tension de seuil pour rendre conducteurs les transistors de cellule de mémoire respectifs des cellules de l'ensemble, de façon qu'un chemin de courant soit formé dans chaque transistor entre des première et seconde bornes de chemin de courant respectives de ce transistor, et on peut également les faire fonctionner pour connecter en parallèle les uns par rapport aux autres les transistors de cellule de mémoire respectifs des cellules de l'ensemble, de façon que leurs premières bornes de chemin de courant respectives soient connectées ensemble à un premier conducteur de connexion (SL), et leurs secondes bornes de chemin de courant respectives soient connectées ensemble à un second conducteur de connexion (613), le signal de mesure étant obtenu à partir de l'un (613; SL) des premier et second conducteurs de connexion.

4. Un dispositif selon la revendication 3, dans lequel les cellules dudit ensemble sont disposées le long du même conducteur de bit ou le long du même groupe de conducteurs de bit (BL0 à BL2).

5. Un dispositif selon la revendication 3 ou 4, dans lequel les cellules dudit ensemble sont disposées le long du même conducteur de mot ou le long du même groupe de conducteurs de mot (WL0 à WL2).

6. Un dispositif selon la revendication 1 ou 2, dans lequel, pour produire le signal de mesure pour une cellule de mémoire individuelle, on peut faire fonctionner les moyens de mesure de tension de seuil pour rendre conducteurs le transistor de cellule de mémoire de la cellule, de façon à former un chemin de courant dans ce transistor entre des première et seconde bornes de chemin de courant de celui-ci, et on peut également les faire fonctionner pour connecter ses première et seconde bornes de chemin de courant respectivement à des premier et second conducteurs de connexion (SL, 613) du dispositif, le signal de mesure étant obtenu à partir de l'un (613; SL) des premier et second conducteurs de connexion.

7. Un dispositif selon l'une quelconque des revendications 3 à 6, dans lequel une tension prédéterminée (VCC) est appliquée à une électrode de commande du transistor de cellule de mémoire de la cellule de mémoire individuelle, ou du transistor de cellule de mémoire de chaque cellule dudit ensemble, selon le cas.

8. Un dispositif selon la revendication 7, dans lequel le signal de mesure représente une différence entre la tension prédéterminée (VCC) et la tension de seuil de la cellule de mémoire individuelle ou de la cellule de mémoire de l'ensemble qui a la vitesse d'effacement la plus élevée.

9. Un dispositif selon la revendication 7 ou 8, dans lequel le signal de référence représente une différence entre la tension prédéterminée (VCC) et la tension de seuil prédéterminée pour la vitesse d'effacement la plus élevée.

10. Un dispositif selon l'une quelconque des revendications 7 à 9, dans lequel la tension prédéterminée est une tension d'alimentation normale (VCC) du dispositif.

11. Un dispositif selon l'une quelconque des revendications 3 à 10, dans lequel la première borne de chemin de courant du transistor de cellule de mémoire ou de chacun d'eux est une borne de source, et la seconde borne de chemin de courant du transistor de cellule de mémoire ou de chacun d'eux est une borne de drain de celui-ci.

12. Un dispositif selon la revendication 11, dans lequel le premier conducteur de connexion (SL) est un conducteur de source connecté en commun à des bornes de source respectives des transistors de cellule de mémoire de toutes les cellules de mémoire de la multiplicité, et le second conducteur de connexion (613) est un bus de données du dispositif ayant pour fonction de connecter un ou plusieurs conducteurs de bit (BL) à l'un des amplificateurs de lecture (608).

13. Un dispositif selon l'une quelconque des revendications précédentes, comprenant en outre des moyens d'effacement qu'on peut faire fonctionner, dans le cas de la détermination du fait qu'aucune des cellules de mémoire de la multiplicité n'a atteint la tension de seuil prédéterminée pour la vitesse d'effacement la plus élevée, pour provoquer l'accomplissement d'une telle opération d'effacement supplémentaire sur les cellules de mémoire de la multiplicité.

14. Un dispositif selon l'une quelconque des revendications précédentes, comprenant en outre :
des moyens de détection de défaut qu'on peut faire fonctionner, à la suite de la détermination par les moyens de comparaison (625; 640) que la tension de seuil de f'une des cellules de mémoire de la multiplicité a atteint la tension de seuil prédéterminée pour la vitesse d'effacement la plus élevée, de façon à accomplir une opération de vérification supplémentaire dans laquelle on détermine individuellement, pour chaque cellule de mémoire de la multiplicité, si la tension de seuil a atteint une tension de seuil prédéterminée pour la vitesse d'effacement la plus basse, qui est la tension de seuil exigée de la cellule de la matrice ayant la vitesse d'effacement la plus basse, et, dans la négative, on détermine que la cellule considérée est défectueuse.

15. Un procédé de vérification d'effacement, pour l'utilisation dans une mémoire à semiconducteur non volatile qui comprend : une matrice (1) de cellules de mémoire effaçable non volatile (M11) formées à des intersections de conducteurs de mot (WL) et de conducteurs de bits (BL), chaque cellule de mémoire comprenant un transistor de cellule de mémoire; un décodeur de ligne (3); un décodeur de colonne (5); et des amplificateurs de lecture (608) correspondant aux conducteurs de bit; ce procédé comprenant les étapes suivantes :
à la suite d'une opération d'effacement sur une multiplicité des cellules de mémoire de la matrice, on produit, pour l'une individuelle de ces cellules de mémoire ou pour un ensemble (605; 606) de ces cellules de mémoire, un signal qui, dans le cas d'une cellule de mémoire individuelle, est représentatif d'une tension de seuil du transistor de cellule de mémoire de la cellule de mémoire individuelle ou qui, dans le cas d'un ensemble, est représentatif d'une tension de seuil du transistor de cellule de mémoire de la cellule de l'ensemble qui a la vitesse d'effacement la plus élevée;
on produit un signal de référence représentatif d'une tension de seuil prédéterminée pour la vitesse d'effacement la plus élevée, qui est la tension de seuil après effacement exigée pour la cellule de la matrice ayant la vitesse d'effacement la plus élevée; et
on compare le signal de mesure, ou chacun d'eux, avec le signal de référence, et on détermine, sur la base de la comparaison ou des comparaisons, si la tension de seuil de l'une quelconque des cellules de mémoire de la multiplicité a atteint la tension de seuil prédéterminée pour la vitesse d'effacement la plus élevée.

16. Un procédé selon la revendication 15, dans lequel, dans le cas où on détermine qu'aucune des cellules de mémoire de la multiplicité n'a atteint la tension de seuil prédéterminée pour la vitesse d'effacement la plus élevée, on commande l'accomplissement d'une telle opération d'effacement supplémentaire sur les cellules de mémoire de la multiplicité.

17. Un procédé selon la revendication 15 ou 16, dans lequel, à la suite d'une détermination du fait que la tension de seuil de l'une des cellules de mémoire de la multiplicité a atteint la tension de seuil prédéterminée pour la vitesse d'effacement la plus élevée, on accomplit une opération de vérification supplémentaire dans laquelle on détermine individuellement, pour chaque cellule de mémoire de la multiplicité, si la tension de seuil a atteint une tension de seuil prédéterminée pour la vitesse d'effacement la plus basse, qui est la tension de seuil exigée pour la ceilule de la matrice ayant la vitesse d'effacement la plus basse et, dans la négative, on détermine que la cellule concernée est défectueuse.

18. Une mémoire non volatile à semiconducteur ayant une matrice (1) de cellules de mémoire effaçable non volatile (Mij) formées à des intersections de conducteurs de mot (WL1 à WLm) et de conducteurs de bits (BL11 à BL1k, ..., BLn1 à BLnk); un décodeur de ligne (3); un décodeur de colonne (5); des amplificateurs de lecture (7) connectés respectivement aux conducteurs de bit (BL11 à BL1k, ..., BLn1 à BLnk), et des moyens de détermination de tension connectés à la matrice, **caractérisée en ce que** les moyens de détermination de tension comprennent :
des moyens de détection de tension (3, 8, 9, 612, 613) pour rendre conducteurs tous les transistors de cellule de mémoire de la matrice et pour les connecter en parallèle les uns par rapport aux autres pour détecter une tension produite par un courant circulant à travers les transistors de cellule de mémoire;
des moyens de génération de tension de référence (628); et
des moyens de comparaison (625) pour comparer une tension de sortie (613) des moyens de détection de tension avec une tension de référence qui est produite par les moyens de génération de tension de référence (628).

19. La mémoire non volatile à semiconducteur selon la revendication 18, dans laquelle :
une tension prédéterminée est appliquée à un conducteur de source connectant ensemble toutes les sources des transistors de cellule de mémoire,
des tensions positives identiques ou différentes sont appliquées au conducteur de source et à la totalité ou une partie de conducteurs de mot qui forment des grilles de commande des transistors de cellule de mémoire,
les drains des transistors de cellule sont connectés à un bus de données, et
les moyens de détermination de tension sont connectés au bus de données.

20. La mémoire non volatile à semiconducteur selon la revendication 18, dans laquelle :
les sources de transistors de cellule de mémoire sont connectées à un seul conducteur de source,
les drains des transistors de cellule sont connectés en commun à un bus de données, des tensions positives identiques ou différentes sont appliquées au bus de données et à la totalité ou à certains des conducteurs de mot qui forment les grilles de commande des transistors de cellule de mémoire, et
les moyens de détermination de tension sont connectés au conducteur de source.
